# EUROPÄISCHE PATENTSCHRIFT

(11) **EP 0 922 929 B1**
(45) Veröffentlichungstag und Bekanntmachung des Hinweises auf die Patenterteilung: **06.05.2004**
(21) Anmeldenummer: 98122085.8
(22) Anmeldetag: 21.11.1998
(51) Int. Cl.: G01B 7/34, G01N 27/00, H01J 37/02

(54) **In einem Rastermodus abtastende Vorrichtung mit einer Kompensation des Störeinflusses von mechanischen Schwingungen auf den Abtastvorgang**
Scanning-probe device with compensation for the disturbing influence of mechanical vibrations on the scanning process
Appareil à sonde de balayage avec compensation pour les effets parasitaires des vibrations mécaniques sur le procédé de balayage

(30) Priorität: 10.12.1997 DE 19754681
(43) Veröffentlichungstag der Anmeldung: 16.06.1999
(73) Patentinhaber: Heiland, Peter, 65479 Raunheim (DE)
(72) Erfinder: Heiland, Peter, 65479 Raunheim (DE)
(74) Vertreter: Blumbach, Kramer & Partner GbR

(56) Entgegenhaltungen:
- EP-A- 0 361 932
- EP-A- 0 422 548
- WO-A-92/03840
- DE-A- 19 718 799
- PATENT ABSTRACTS OF JAPAN vol. 017, no. 412 (P-1583), 30. Juli 1993 -& JP 05 079811 A (NIKON CORP), 30. März 1993
- PATENT ABSTRACTS OF JAPAN vol. 018, no. 475 (E-1601), 5. September 1994 & JP 06 162982 A (HITACHI LTD), 10. Juni 1994
- PATENT ABSTRACTS OF JAPAN vol. 097, no. 004, 30. April 1997 & JP 08 321274 A (HITACHI LTD), 3. Dezember 1996

## Beschreibung

Die Erfindung betrifft eine in einem Rastermodus abtastende Vorrichtung, insbesondere ein Rastermikroskop, mit einer Kompensation des Störeinflusses von mechanischen Schwingungen auf den Abtastvorgang entsprechend dem Oberbegriff des Anspruchs 1.

Vorrichtungen, welche im Raster-Scanning-Verfahren eine Probe abtasten, haben in den letzten Jahren vor allem aufgrund verbesserter Verschiebeeinrichtungen, beispielsweise hochgenaue Piezotranslatoren und der fortschreitenden Entwicklung bei der Herstellung von Sensoren und Prüfspitzen, welche je nach Ausführungsform beispielsweise einen Tunnelstrom aufnehmen oder eine Krafteinwirkung anzeigen, insbesonders bei hochauflösenden Untersuchungen von Proben eine große Bedeutung erlangt. Mit derartigen Vorrichtungen läßt sich leicht die Topographie einer Probe aufnehmen oder ortsaufgelöst Bindungsverhältnisse, beispielsweise von Makromolekülen, offenlegen. Hierbei werden Auflösungen bis in den Nanometer- bzw. den Subnanometerbereich erreicht. Aus diesem Grund hängt das reale Auflösungsvermögen derartiger Vorrichtungen stark von den äußeren Umgebungseinflüssen ab. Hierbei spielt insbesondere der Störeinfluß von mechanischen Schwingungen, beispielsweise Luftschwingungen oder auch Körperschwingungen, welche beispielsweise durch Gebäudebewegungen erzeugt werden können, eine große Rolle. Die auf diese Weise erzeugten Störbewegungen, beispielsweise des Mikroskoptisches auf welchem die Probe aufliegt, können leicht in einer Größenordnung von mehreren Mikrometern liegen, was einem Signal-Rausch-Verhältnis von < 10⁻³ entspricht. Das hohe Auflösungsvermögen der Vorrichtungen läßt sich damit nur dann ausnutzen, wenn der Störeinfluß durch entsprechende Einrichtungen vermindert wird.

Nach dem Stand der Technik werden beispielsweise aktive oder passive Schwingungsdämpfungs- oder Schwingungsisolationseinrichtungen verwendet. Derartige Einrichtungen sind jedoch sehr kostenintensiv. Vor allem bei sehr niedrigen Störfrequenzen, wie sie beispielsweise bei Gebäudeschwingungen vorkommen können, bieten diese Einrichtungen weiterhin nur einen eingeschränkten Schutz. Zusätzlich sind solche Systeme aufgrund des mechanischen Einschwingverhaltens recht langsam.

Die EP-A-0 361 932 beschreibt ein Rastertunnelmikroskop, bei dem der Probenhalter sowohl in der X-Y-Ebene als auch in Z-Richtung verschiebbar ist. Die Sonde des Rastertunnelmikroskops kann über ein zylindrisches Piezoelement zum Scannen der Probe ebenfalls in allen drei Raumrichtungen gegenüber der Probe bewegt werden. Sie wird über ein Stellglied so gesteuert, dass der Abstand zwischen Probe und Sonde konstant bleibt. Eine zweite Tunnelstromsonde, die nicht zum Scannen verwendet wird, überwacht als Schwingungssensor den Abstand zwischen Probe und Sonden und führt bei schwingungsbedingten Änderungen den Probenhalter in Z-Richtung entsprechend nach. Somit werden Störeinflüsse von mechanischen Schwingungen auf den Abtastvorgang aufgehoben. Alternativ kann das Signal der zweiten Sonde auch nur in die Datenaufbereitung des eigentlichen Abtastsignals einfliessen, so dass schwingungsbedingte Störungen bei der Darstellung des eigentlichen Abtastsignals unterdrückt werden.

Aufgabe der Erfindung ist es somit, eine Vorrichtung bereitzustellen, welche die Nachteile der Vorrichtungen nach dem Stand der Technik nicht aufweist.

Dies wird überraschend einfach durch eine Vorrichtung nach Anspruch 1 und ein Verfahren zum Betrieb einer derartigen Vorrichtung nach Anspruch 11 bereitgestellt. Danach umfaßt die in einem Rastermodus abtastende Vorrichtung einen Sensor zur Erfassung von mechanischen Schwingungen, welcher einen Filter ansteuert, dessen Ausgang zusammen mit dem Ausgang der Einrichtung zur Erzeugung eines Stellsignals an einen Summierer angeschlossen ist, wobei der Ausgang des Summierers die Einrichtung zum Ändern des Abstandes zwischen der Probe und dem Sensor steuert, so daß der Störeinfluß von mechanischen Schwingungen auf den Abtastvorgang im wesentlichen aufgehoben wird.

Der finanzielle Aufwand für eine erfindungsgemäße Vorrichtung, insbesondere zum Beseitigen des Störeinflusses von mechanischen Schwingungen, ist im Vergleich zu Vorrichtungen nach dem Stand der Technik minimal. Da für die Kompensation des Störeinflusses neben dem Sensor zur Erfassung der mechanischen Schwingungen nur elektrische Komponenten verwendet werden, ist das Antwortverhalten auf die äußeren Störungen extrem schnell und wird weiterhin bezüglich der Frequenz nicht vom Einschwingverhalten anderer mechanischer Einrichtungen beschränkt.

Ist der Filter regelbar und der Ausgang des Summierers am Regeleingang des Filters angeschlossen, kann durch diese Rückkopplung das Ausgangssignal des Summierers durch Adaption des Filters zeitlich im wesentlichen konstant gehalten und somit der Einfluß von mechanischen Schwingungen auf dem Abtastvorgang automatisch kompensiert werden. Um den Einfluß der Störung auf das Meßsignal von einer realen Meßwertänderung aufgrund des "Anfahrens" eines anderen Meßpunktes auf der Probe zu trennen, wird die Adaption oder der Abgleich des Filters zu Zeitpunkten durchgeführt, an denen die Verschiebeeinrichtung nicht aktiv und der Meßvorgang für den entsprechenden Punkt auf der Probe abgeschlossen ist.

Um die Adaption des Filters zu vereinfachen, kann der Filter digital ausgebildet sein. Die Anordnung des Sensors zur Erfassung der mechanischen Schwingungen kann für den jeweiligen Aufbau optimiert werden, beispielsweise kann der Sensor an einem Mikroskoptisch angebracht sein, auf welchem die in einem Rastermodus abtastende Vorrichtung aufliegt, womit der Sensor zur Erfassung der mechanischen Schwingungen benachbart zur Probe angeordnet ist. In bestimmten Fällen ist es jedoch auch möglich, diesen Sensor an einem entfernteren Ort, beispielsweise auf dem Boden, an welchem sich der Mikroskoptisch abstützt, anzuordnen.

Der Sensor zur Erfassung der mechanischen Schwingungen kann je nach Anforderung die Elongation und/oder die Beschleunigung der zugeordneten Schwingung aufnehmen. Die Erfassung der Beschleunigung ermöglicht eine schnellere Reaktion des Systems auf die Störung.

Je nach dem Grad der erforderlichen Kompensation kann ein Schwingungssensor zur Erfassung der mechanischen Schwingungen im wesentlichen senkrecht zur Verschiebungsebene umfaßt sein, es kann jedoch auch ein Schwingungssensor, welcher mechanische Schwingungen dreiachsig erfaßt, verwendet werden. Damit lassen sich beispielsweise auch Störungen, welche eine Verschiebung der Probe und des Sensors relativ zueinander in der Verschiebungsebene verursachen, erfassen. Dies betrifft insbesondere auch Störschwingungen, die durch die Vorrichtung selbst hervorgerufen werden, z.B. durch die Verschiebeeinrichtung, die beispielsweise den Sensor über die Probe bewegt.

Sind die drei Ausgänge des dreiachsigen Schwingungssensors jeweils am Eingang eines Filters angeschlossen, wobei die Ausgänge der Filter auf den Summierer aufgeschaltet sind, lassen sich die Störungen des Meßsignals für alle drei Raumrichtungen berücksichtigen und kompensieren. Sind alle Filter jeweils regelbar, und der Ausgang des Summierers jeweils am Regeleingang der Filter angeschlossen, so werden wirkungsvoll durch Adaption der einzelnen Filter derart, daß das Signal am Ausgang des Summierers zeitlich im wesentlichen konstant ist, alle Störungen, welche durch Schwingungen hervorgerufen werden, im wesentlichen kompensiert.

Die erfindungsgemäße Vorrichtung läßt sich für alle in einem Rastermodus abtastende Vorrichtungen verwenden. Dies betrifft insbesondere Kraftmikroskope, beispielsweise "Atomic Force"-Mikroskope oder "van der Waals"-Mikroskope sowie elektronische und optische Rastertunnelmikroskope.

Weiterhin besteht die Möglichkeit, vorhandene, in einem Rastermodus abtastende Vorrichtungen gemäß der Erfindung umzubauen oder die erfindungsgemäße Vorrichtung mit mechanischen Schwingungsdämpfungs- und Isolationsvorrichtungen zu kombinieren.

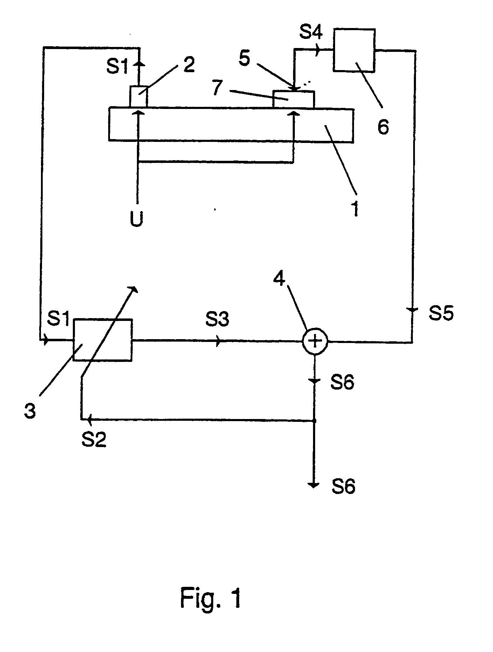

Die Erfindung wird im folgenden durch Beschreiben einiger Ausführungsformen unter Bezugnahme auf die anliegende Zeichnung erläutert, wobei: Fig. 1 schematisch eine erfindungsgemäße Vorrichtung zeigt.

Die in Fig. 1 dargestellte erfindungsgemäße, in einem Rastermodus abtastende Vorrichtung mit einer Kompensation des Störeinflusses von mechanischen Schwingungen auf den Abtastvorgang umfaßt einen Sensor 5 zur Erfassung eines Meßsignals S4, das vom Abstand des Sensors zu einer auf einem Mikroskoptisch 1 aufliegenden Probe 7 abhängt.

Das Meßsignal S4 wird einer elektronischen Schaltung 6 zugeführt, welche ein Stellsignal S5 zum Ändern des Abstandes zwischen dem jeweiligen Meßbereich beziehungsweise dem jeweiligen Meßpunkt auf der Probe und dem Sensor erzeugt. Dieses Stellsignal S5 wird jedoch nicht wie in Vorrichtungen nach dem Stand der Technik direkt der Einrichtung zum Ändern des Abstandes zwischen der Probe und dem Sensor, sondern einem Addierer 4 zugeführt. Die erfindungsgemäße Vorrichtung umfaßt ferner einen Sensor 2 zur Erfassung von mechanischen Schwingungen, welcher mit einem Ausgangssignal S1 den Eingang eines Filters 3 ansteuert, dessen Ausgang auch an den Summierer 4 angeschlossen ist. Dieser addiert somit das Signal S3 aus dem Filter und das Signal S5 aus.der Einrichtung zur Erzeugung des Stellsignals zu einem Signal S6. Durch Abgleich des Filters 3 wird erreicht, daß das resultierende Signal S6 im wesentlichen unabhängig von der Zeit und somit unabhängig von der Störung ist. Die Probe wird durch Ansteuern einer Verschiebeeinrichtung zum rasterförmigen Verschieben, je nach Ausführungsform, der Probe 7 und/oder des Sensors 5 abgetastet und somit deren Topographie ermittelt.

Nach dem Verändern der relativen Lage der Probe und des Sensors in einer Ebene, welche in einer Ausführungsform der Erfindung im wesentlichen parallel zum Mikroskoptisch ist, wird ein neuer Punkt auf der Probe erfaßt, und in einer Ausführungsform durch Verändern des relativen Abstandes der Probe und des Sensors zueinander im wesentlichen senkrecht zur ebengenannten Ebene wieder auf ein konstantes Meßsignal S4 eingestellt. Die relative Änderung des Abstandes der Probe und des Sensors ist eine absolutes Maß für den Höhenunterschied der beiden benachbarten Meßpunkte auf der Probe.

In einer Ausführungsform der Erfindung ist der Filter 3 regelbar ausgeführt, wobei der Ausgang des Summierers 4 am Regeleingang des Filters angeschlossen ist. Somit dient das Summensignal S6 auch als Fehlersignal für die Einstellung der Parameter des adaptiven Filters 3. Da diese Rückkopplung rein elektronisch ausgeführt ist, wird im Vergleich zu mechanischen Rückkopplungssystemen ein schneller Abgleich des Filters derart erreicht, daß das Signal S6 im wesentlichen zeitlich konstant ist, wenn die Verschiebeeinrichtung der Vorrichtung nicht aktiv ist. Je nach Ausführungsform der Erfindung kann der Filter 3 als analoger oder digitaler Filter ausgeführt sein.

Der Sensor 2 zur Erfassung von mechanischen Schwingungen ist in der Nähe zur Probe angeordnet. Die genaue Lage spielt eine untergeordnete Rolle. In jedem Fall muß jedoch die Störung U einen Einfluß sowohl auf die relative Lage zwischen der Probe und dem Sensor 5 als auch auf das Signal des Sensors 2 haben. Der Schwingungssensor 2 kann sowohl als Translationsaufnehmer als auch als Beschleunigungsaufnehmer ausgeführt werden. In einer besonderen Ausführungsform der Erfindung ist der Schwingungssensor dreiachsig ausgeführt und erfaßt somit sowohl Schwingungen der Verschiebungsebene als auch senkrecht dazu. Die drei Ausgänge des Sensors sind jeweils an einem Eingang eines Filters angeschlossen, wobei die Ausgänge der Filter alle auf den Summierer 4 aufgeschaltet sind. Durch Einstellen der jeweiligen Filter wird wie obenstehend erreicht, daß das Signal S6 zum Einstellen des Abstandes zwischen der Probe 7 und dem Sensor 5 im wesentlichen zeitlich konstant ist. Ein automatischer Ausgleich der durch die mechanischen Schwingungen in den drei Raumrichtungen verursachten Störungen, welche jeweils Auswirkungen auf den Relativabstand zwischen der Probe und dem Sensor 5 und somit auf das Meßsignal S4 haben, wird wirkungsvoll in einer besonderen Ausführungsform der Erfindung kompensiert, bei welcher die drei Filter regelbar sind und der Ausgang des Summierers 4 jeweils am Regeleingang der Filter angeschlossen ist. Durch automatische Adaption der Parameter der drei Digitalfilter wird sichergestellt, daß zu jedem Zeitpunkt, an dem die Verschiebeeinrichtung nicht aktiv ist, das Signal S6 zeitlich im wesentlichen nicht variiert.

Die erfindungsgemäße Vorrichtung kann je nach Ausführungsform ein Kraftmikroskop, beispielsweise ein "Atomic Force"-Mikroskop oder ein "Van der Waals"-Mikroskop, bzw. ein Rastertunnelmikroskop, beispielsweise ein Elektronen-Rastertunnelmikroskop oder ein optisches Rastertunnelmikroskop, sein. Im Falle eines "Atomic Force"-Mikroskopes umfaßt der Sensor 5 eine Prüfspitze an einem Hebelarm, welcher in Schwingungen versetzt wird. Der Abstand des Probenpunktes und der Prüfspitze kann sich beim Scannen durch das relative Verschieben der Probe und des Sensors in der Horizontalen zueinander verändern. Diese Abstandsänderung hat eine Verstimmung des schwingenden Hebelarms zur Folge, welche durch Änderung des vertikalen Abstandes zwischen der Spitze und dem Meßpunkt an der Probenoberfläche wieder rückgängig gemacht wird.

Um beispielsweise die Topographie einer Probe zu ermitteln, kann das Meßsignal S4, welches durch die Prüfspitze aufgenommen wird und vom Abstand des jeweiligen Meßpunktes auf der Probe zur Prüfspitze abhängt, während des Scannens der Probe konstant gehalten werden. Dies kann dadurch erreicht werden, daß nach dem "Anfahren" eines neuen Meßpunktes auf der Probe der Abstandes zwischen dem jeweiligen Meßpunkt und der Spitze derart geändert wird, daß das Meßsignal einen fest vorgegebenen Wert besitzt. Da ein vorgegebenes Meßsignal S4 einem bestimmten Abstand des Sensors und dem Meßpunkt auf der Probe entspricht, wird somit die Vorrichtung immer auf einen festen Abstand des Sensors zu den jeweiligen Meßpunkten geregelt. Muß nach dem "Anfahren" eines neuen Meßpunktes der Abstand zwischen dem Sensor und dem neuen Meßpunkt um eine Strecke geändert werden, bedeutet dies, daß der neue Meßpunkt in z-Richtung relativ zum alten Meßpunkt um genau diese Strecke höher beziehungsweise niedriger liegt als der vorhergehende Meßpunkt. Die Einrichtung zur Erzeugung eines Stellsignal zum Ändern des Abstandes zwischen dem Sensor 5 und der Probe 7 erzeugt hierfür das z-Signal S5, welches zeitlich variierende Komponenten aufgrund mechanischer Vibrationen aufweisen kann. Wie schon obenstehend erläutert, wird dieses Signal S5 zusammen mit dem Signal S3 aus dem Filter 3 im Summierer 4 addiert, im welchem das Stellsignal S6 zum Ändern des Abstandes zwischen dem Sensor 5 und der Probe 7 erzeugt wird, das zeitlich im wesentlichen konstant ist. Bei idealer Adaption des Filters 3 erzeugt der Filter aus dem Eingangssignal S1 ein Signal S3, welches betragsmäßig gleich dem zeitlich variierenden Anteil des Signals S5 ist, nur mit umgekehrten Vorzeichen, so daß sich beide Komponenten gerade aufheben. Erfindungsgemäß werden die durch mechanische Schwingungen hervorgerufenen Störungen auf den Abstand der Prüfspitze vom Prüfort auf der Probenoberfläche auf diese Weise im wesentlichen kompensiert.

Die Adaption des Filters 3 kann je nach Ausführungsform der Erfindung an jedem Meßpunkt oder in vorgegebenen Zeitabständen durchgeführt werden. Während des Scannvorganges selbst, d.h. während des Verschiebens der Probe relativ zum Sensor 5 in einer Ebene, welche im wesentlichen senkrecht zur z-Richtung liegt, werden die vorher ermittelten Parameter zum Einstellen des Filters 3 beibehalten.

## Patentansprüche

1. In einem Rastermodus abtastende Vorrichtung, insbesondere ein Rastermikroskop, mit einer Kompensation des Störeinflusses von mechanischen Schwingungen auf den Abtastvorgang, umfassend:
- einen Sensor (5) zur Erfassung eines Meßsignals (S4), welches vom Abstand des Sensors zu einer Probe (7) abhängt;
- eine Verschiebeeinrichtung zum Verschieben der Probe (7) und/oder des Sensors (5) relativ zueinander;
- eine Einrichtung zum Ändern des Abstandes zwischen der Probe (7) und dem Sensor (5),
- eine dem Sensor (5) nachgeschaltete Einrichtung (6) zur Erzeugung eines Stellsignals (S5) zum Ändern des Abstandes zwischen der Probe (7) und dem Sensor (5);
**dadurch gekennzeichnet, daß**
die Vorrichtung ferner einen Sensor (2) zur Erfassung von mechanischen Schwingungen aufweist, welcher einen Filter (3) ansteuert, dessen Ausgang zusammen mit dem Ausgang der Einrichtung zur Erzeugung eines Stellsignals an einen Summierer (4) angeschlossen ist, wobei der Ausgang des Summierers (4) die Einrichtung zum Ändern des Abstandes zwischen der Probe (7) und dem Sensor (5) ansteuert.

2. Vorrichtung nach Anspruch 1,
**dadurch gekennzeichnet, daß** die Verschiebeeinrichtung die Probe (7) und/oder den Sensor (5) im wesentlichen in einer Ebene verschiebt und die Einrichtung zum Ändern des Abstandes zwischen der Probe (7) und dem Sensor (5) den Abstand in einer Richtung ändert, die im wesentlichen senkrecht zur Verschiebungsebene liegt.

3. Vorrichtung nach Anspruch 1 oder 2,
**dadurch gekennzeichnet, daß** der Filter (3) regelbar ist und der Ausgang des Summierers (4) am Regeleingang des Filters (3) angeschlossen ist.

4. Vorrichtung nach Anspruch 1,2 oder 3,
**dadurch gekennzeichnet, daß** der Filter (3) ein digitaler Filter ist.

5. Vorrichtung nach einem der vorstehenden Ansprüche,
**dadurch gekennzeichnet, daß** der Sensor (2) zur Erfassung von mechanischen Schwingungen benachbart zur Probe (7) angeordnet ist.

6. Vorrichtung nach einem der vorstehenden Ansprüche,
**dadurch gekennzeichnet, daß** der Sensor (2) zur Erfassung von mechanischen Schwingungen die Elongation oder die Beschleunigung der Schwingung erfaßt.

7. Vorrichtung nach einem der vorstehenden Ansprüche,
**dadurch gekennzeichnet, daß** der Schwingungssensor (2) mechanische Schwingungen im wesentlichen senkrecht zur Verschiebungsebene erfaßt.

8. Vorrichtung nach einem der vorstehenden Ansprüche,
**dadurch gekennzeichnet, daß** der Schwingungssensor (2) mechanische Schwingungen dreiachsig erfaßt und die den Richtungen zugeordneten drei Ausgänge des Sensors (2) jeweils am Eingang eines Filters angeschlossen sind, wobei die Ausgänge der Filter auf den Summierer (4) aufgeschaltet sind.

9. Vorrichtung nach Anspruch 8,
**dadurch gekennzeichnet, daß** die Filter regelbar sind und der Ausgang des Summierers jeweils am Regeleingang eines Filters angeschlossen ist.

10. Vorrichtung nach einem der vorstehenden Ansprüche,
**dadurch gekennzeichnet, daß** die Vorrichtung ein Kraftmikroskop oder ein Tunnelmikroskop ist.

11. Verfahren zum Betrieb einer in einem Rastermodus abtastenden Vorrichtung, insbesondere zum Betrieb einer Vorrichtungen nach einem der vorstehenden Ansprüche 1 bis 8,
**dadurch gekennzeichnet, daß** mittels eines Sensors (2) mechanische Schwingungen erfaßt werden und mit dem Sensorsignal ein Filter (3) angesteuert wird, dessen Ausgangssignal zusammen mit dem Ausgangssignal einer Einrichtung zur Erzeugung eines Stellsignals an dem Eingangs eines Summierer (4) anliegt, mit dessen Ausgangssignal eine Einrichtung zum Ändern des Abstandes zwischen der Probe (7) und dem Sensor (5) gesteuert wird, so daß der Störeinfluß von mechanischen Schwingungen auf den Abtastvorgang im wesentlichen aufgehoben wird.

12. Verfahren nach Anspruch 11,
**dadurch gekennzeichnet, daß** das Meßsignal (S4) während des Verschiebens der Probe (7) und/oder des Sensors (5) durch Ändern des Abstandes zwischen der Probe und dem Sensor konstant gehalten wird.

13. Verfahren nach Anspruch 11 oder 12,
**dadurch gekennzeichnet, daß** der Filter (3) durch das Ausgangssignal des Summierers (4) derart geregelt wird, daß im abgeglichenen Zustand das Ausgangssignal des Summierers zeitlich im wesentlichen konstant ist.

14. Verfahren nach einem der Ansprüche 11, 12 oder 13,
**dadurch gekennzeichnet, daß** das Abgleichen des Filters (3) zu Zeitpunkten erfolgt, an denen die Verschiebeeinrichtung nicht aktiv ist.

## Claims

1. A scanning-probe device, particularly a scanning microscope, with compensation for the disturbing influence of mechanical vibrations on the scanning process, comprising:
- a sensor (5) for detecting a measurement signal (S4) which depends on the distance of the sensor from a sample (7);
- a displacement device for displacing the sample (7) and/or the sensor (5) relatively to one another;
- a device for changing the distance between the sample (7) and the sensor (5),
- a device (6) connected downstream of the sensor (5) for producing an actuation signal (S5) to change the distance between the sample (7) and the sensor (5),
**characterised in that**
the device also comprises a sensor (2) for detecting mechanical vibrations, said sensor (2) actuating a filter (3) of which the output is connected, together with the output for the device for generating an actuation signal, to an adder (4), the output of the adder (4) actuating the device for changing the distance between the sample (7) and the sensor (5).

2. A device according to claim 1, **characterised in that** the displacement device displaces the sample (7) and/or the sensor (5) substantially in one plane and the device for changing the distance between the sample (7) and the sensor (5) changes the distance in a direction substantially perpendicular to the displacement plane.

3. A device according to claim 1 or 2,
**characterised in that** the filter (3) is controllable and the output of the adder (4) is connected to the control input of the filter (3).

4. A device according to claim 1, 2 or 3,
**characterised in that** the filter (3) is a digital filter.

5. A device according to any one of the preceding claims, **characterised in that** the sensor (2) for detecting mechanical vibrations is disposed adjacent the sample (7).

6. A device according to any one of the preceding claims, **characterised in that** the sensor (2) for detecting mechanical vibrations detects the elongation or acceleration of the vibration.

7. A device according to any one of the preceding claims, **characterised in that** the vibration sensor (2) detects mechanical vibrations substantially perpendicular to the displacement plane.

8. A device according to any one of the preceding claims, **characterised in that** the vibration sensor (2) detects mechanical vibrations triaxially and the three outputs of the sensor (2) associated with the directions are each connected to the input of a filter, the filter outputs being connected to the adder (4).

9. A device according to claim 8, **characterised in that** the filters are controllable and the output of the adder is in each case connected to the control input of a filter.

10. A device according to any one of the preceding claims, **characterised in that** the device is a force microscope or a tunnelling microscope.

11. A method of operating a scanning-probe device, particularly for operating a device according to any one of the above claims 1 to 8, **characterised in that** by means of a sensor (2) mechanical vibrations are detected and with the sensor signal a filter (3) is actuated, the output signal of which together with the output signal of a device for generating an actuation signal is applied to the input of an adder (4), by means of the output signal of which a device for changing the distance between sample (7) and the sensor (5) is controlled so that the disturbing influence of mechanical vibrations on the scanning process is substantially eliminated.

12. A method according to claim 11, **characterised in that** the measurement signal (S4) is kept constant during displacement of the sample (7) and/or of the sensor (5) by changing the distance between the sample and the sensor.

13. A method according to claim 11 or 12,
**characterised in that** the filter (3) is so controlled by the output signal of the adder (4) that in the balanced state the output signal of the adder is substantially constant in time.

14. A method according to any one of claims 11, 12 or 13, **characterised in that** balancing of the filter (3) is carried out at times at which the displacement device is not active.

## Revendications

1. Dispositif d'échantillonnage à mode balayage, notamment microscope à balayage, avec une compensation de l'influence parasitaire de vibrations mécaniques sur l'opération de balayage, comprenant :
- un capteur (5) pour la détection d'un signal de mesure (S4) qui dépend de la distance du capteur à un échantillon (7) ;
- un dispositif de déplacement pour déplacer l'échantillon (7) et/ou le capteur (5) l'un par rapport à l'autre ;
- un dispositif pour modifier la distance entre l'échantillon (7) et le capteur (5) ;
- un dispositif (6) branché en aval du capteur (5) pour produire un signal de commande (S5) pour modifier la distance entre l'échantillon (7) et le capteur (5) ;
**caractérisé par le fait que** le dispositif comporte en plus un capteur (2) qui est destiné à la détection de vibrations mécaniques et qui commande un filtre (3) dont la sortie est raccordée, conjointement à la sortie du dispositif destiné à la production d'un signal de commande, à un additionneur (4), la sortie de l'additionneur (4) commandant le dispositif destiné à la modification de la distance entre l'échantillon (7) et le capteur (5).

2. Dispositif selon la revendication 1,
**caractérisé par le fait que** le dispositif de déplacement déplace l'échantillon (7) et/ou le capteur (5) globalement dans un plan et que le dispositif destiné à la modification de la distance entre l'échantillon (7) et le capteur (5) modifie la distance dans une direction qui est globalement perpendiculaire au plan de déplacement.

3. Dispositif selon la revendication 1 ou 2,
**caractérisé par le fait que** le filtre (3) est réglable et que la sortie de l'additionneur (4) est raccordée à l'entrée de réglage du filtre (3).

4. Dispositif selon la revendication 1, 2 ou 3,
**caractérisé par le fait que** le filtre (3) est un filtre numérique.

5. Dispositif selon l'une des revendications précédentes,
**caractérisé par le fait que** le capteur (2) destiné à la détection de vibrations mécaniques est disposé au voisinage de l'échantillon (7).

6. Dispositif selon l'une des revendications précédentes,
**caractérisé par le fait que** le capteur (2) destiné à la détection de vibrations mécaniques détecte l'élongation ou l'accélération de la vibration.

7. Dispositif selon l'une des revendications précédentes,
**caractérisé par le fait que** le capteur de vibration (2) détecte des vibrations mécaniques globalement perpendiculairement au plan de déplacement.

8. Dispositif selon l'une des revendications précédentes,
**caractérisé par le fait que** le capteur de vibration (2) détecte des vibrations mécaniques selon trois axes et que les trois sorties, associées aux directions, du capteur (2) sont raccordées à chaque fois à l'entrée d'un filtre, les sorties des filtres étant branchées sur l'additionneur (4).

9. Dispositif selon la revendication 8,
**caractérisé par le fait que** les filtres sont réglables et que la sortie de l'additionneur est raccordée à chaque fois à l'entrée de réglage d'un filtre.

10. Dispositif selon l'une des revendications précédentes,
**caractérisé par le fait que** le dispositif est un microscope à force ou un microscope à effet tunnel.

11. Procédé pour faire fonctionner un dispositif d'échantillonnage à mode balayage, notamment pour faire fonctionner un dispositif selon l'une des revendications précédentes 1 à 8,
**caractérisé par le fait qu'**on détecte des vibrations mécaniques au moyen d'un capteur (2) et on commande avec le signal de capteur un filtre (3) dont le signal de sortie est appliqué, conjointement au signal de sortie d'un dispositif destiné à la production d'un signal de réglage, à l'entrée d'un additionneur (4) avec le signal de sortie duquel on commande un dispositif destiné à la modification de la distance entre l'échantillon (7) et le capteur (5) de telle sorte que l'influence parasitaire de vibrations mécaniques sur l'opération d'échantillonnage est supprimée pour l'essentiel.

12. Procédé selon la revendication 11,
**caractérisé par le fait qu'**on maintient constant le signal de mesure (S4) pendant le déplacement de l'échantillon (7) et/ou du capteur (5) en modifiant la distance entre l'échantillon et le capteur.

13. Procédé selon la revendication 11 ou 12,
**caractérisé par le fait qu'**on règle le filtre (3) au moyen du signal de sortie de l'additionneur (4) de telle sorte que, à l'état égalisé, le signal de sortie de l'additionneur est globalement constant dans le temps.

14. Procédé selon l'une des revendications 11, 12 ou 13,
**caractérisé par le fait que** l'égalisation du filtre (3) s'effectue à des instants auxquels le dispositif de déplacement n'est pas actif.
